# EUROPEAN PATENT APPLICATION

(11) **EP 4 383 531 A1**
(43) Date of publication of application: **12.06.2024**
(21) Application number: 22853276.8
(22) Date of filing: 05.07.2022
(51) Int. Cl.: H02K 5/22, H02K 3/50, H02K 5/18, H05K 3/34, H05K 1/02

(54) **MOTOR AND CONTROL DEVICE**

(30) Priority: 06.08.2021 KR 20210103957; 14.10.2021 KR 20210136954
(71) Applicant: LG INNOTEK CO., LTD., Seoul 07796 (KR)
(72) Inventor: LEE, Seung Hyeong, Seoul 07796 (KR); AN, Jae Bin, Seoul 07796 (KR); SONG, Kun Yong, Seoul 07796 (KR)
(74) Representative: M. Zardi & Co S.A.
(86) International application number: PCT/KR2022/009653
(87) International publication number: WO 2023/013897

(57) **Abstract**

A motor comprises: a body; a busbar coupled to the body; and a heat transfer member disposed on the body, wherein the body includes a first open area for exposing the busbar in the axial direction, and a second open area, the second open area includes a first unit open area and a second unit open area, and the heat transfer member is in contact with the busbar in the first open area and is disposed between the first unit open area and the second unit open area.

## Description

### [Technical Field]

The present embodiment relates to a motor and a control device.

### [Background Art]

The motor includes a housing, a stator being disposed inside the housing, and a rotor being disposed inside the stator, and is a device that generates rotational motion by electromagnetic interaction between the stator and the rotor. Specifically, a coil is wound on the stator, and a magnet facing the coil is disposed on the rotor, so that the rotor can rotate by the action of the coil and magnet.

In general, motors being used in vehicles often connect multiple coils in parallel to reduce losses due to coil resistance. Therefore, when connecting in parallel, a method in which coils are extended up to an input/output terminal and comprehensively connected at the terminal is used.

Therefore, a busbar module is disposed on an upper side of a stator to connect the coils disposed in parallel. The busbar module is disposed to correspond to an upper surface of a stator and may include a busbar for connection to the coil terminal. To implement a three-phase circuit, the busbar includes a plurality of busbars with different polarities.

During the driving process of the motor, the components within the motor, including the busbar, generate heat, but according to the motor according to the prior art, there is no separate heat dissipation structure within the motor, so there is a risk of deformation of the housing or malfunction of the electrical components..

### [Detailed Description of the Invention]

### [Technical Subject]

The present embodiment is intended to provide a motor that can enhance heat dissipation efficiency by improving the structure.

In addition, it is intended to provide a control device that can improve heat dissipation efficiency by improving the structure.

### [Technical Solution]

A motor according to an embodiment comprises: a body; a busbar being coupled to the body; and a heat transfer member being disposed on the body, wherein the body includes a first open area for exposing the busbar in an axial direction, and a second open area, the second open area includes a first unit open area and a second unit open area, and the heat transfer member is in contact with the busbar in the first open area and is disposed between the first unit open area and the second unit open area.

The heat transfer member may be formed of a material different from the body.

A side wall may be disposed between the first open area and the second open area.

The length of the side wall forming the inner surface of the first open area in a radial direction may be greater than the length of the side wall in a radial direction forming the inner surface of the second open area.

The length of the first open area in a circumferential direction may be smaller than the length of the second open area in a circumferential direction.

The busbar includes a busbar body being extended in a circumferential direction and a protrusion extended in a radial direction from the busbar body, wherein at least a portion of the busbar body is disposed in the first open area, and wherein at least a portion of the protrusion may be disposed in the second open area.

The cross-sectional shape of the heat transfer member may correspond to the cross-sectional shape of the first open area.

The second body may include a groove that opens the busbar upward.

The busbar includes a first busbar of a first polarity, a second busbar of a second polarity different from the first polarity, and a third busbar of a third polarity different from the first polarity and the second polarity, wherein the first to third busbars may be disposed to be spaced apart from each other along a radial direction.

A control device according to an embodiment of the present invention comprises: a printed circuit board including a plurality of holes; a plurality of electronic components being disposed on the plurality of holes on one side of the printed circuit board; and a terminal being disposed on the other side of the printed circuit board, wherein the printed circuit board includes a first path electrically connecting at least a apart among the plurality of electronic components, and wherein the terminal may include a second path being connected to the plurality of holes and electrically connecting at least a part among the plurality of electronic components.

### [Advantageous Effects]

Since the busbar is exposed above the body through a plurality of open areas through the present embodiment, there is an advantage that heat dissipation efficiency is enhanced as the heat dissipation area increases.

In addition, since the busbar has a structure in which heat is directly dissipated through the heat transfer member, there is an advantage that heat can be easily discharged to the outside along the predetermined path.

In addition, by forming an additional connection path between the pluralities of electronic components through the terminal, there is an advantage of reducing the amount of heat generated by the printed circuit board due to a reduction in the resistance component of the electrical connection section.

In addition, since the heat of the electronic component is directly transferred to the terminal, filler, and cover through the metal material filled in the hole, there is an advantage in that the heat dissipation area can be increased and heat dissipation efficiency can be enhanced.

### [Brief Description of Drawings]

FIG. 1 is a perspective view illustrating the outer appearance of a motor according to an embodiment of the present invention.
FIG. 2 is a plan view illustrating an upper surface of a motor according to an embodiment of the present invention.
FIG. 3 is a cross-sectional view illustrating the configuration inside a motor according to an embodiment of the present invention.
FIG. 4 is an exploded perspective view of the housing and a busbar module according to an embodiment of the present invention.
FIG. 5 is an exploded perspective view of a housing, a stator, and a busbar module according to an embodiment of the present invention.
FIG. 6 is a view illustrating FIG. 5 from another angle.
FIG. 7 is a plan view illustrating an upper surface of a busbar module according to an embodiment of the present invention.
FIG. 8 is an exploded perspective view of a plurality of busbars according to an embodiment of the present invention.
FIG. 9 is a diagram for explaining the arrangement structure of a busbar in a busbar module according to an embodiment of the present invention.
FIG. 10 is a diagram for explaining heat dissipation efficiency between a busbar module according to the prior art and a busbar module according to an embodiment of the present invention.
FIGS. 11 and 12 are diagrams illustrating a modified embodiment of a busbar module according to an embodiment of the present invention.
FIG. 13 is a perspective view of a control device according to an embodiment of the present invention.
FIG. 14 is a perspective view illustrating a side surface of a heat dissipation structure in a control device according to an embodiment of the present invention.
FIG. 15 is a plan view illustrating a terminal coupled to a printed circuit board according to an embodiment of the present invention.
FIG. 16 is an exploded perspective view of a heat dissipation structure in a control device according to an embodiment of the present invention.
FIG. 17 is a view illustrating FIG. 16 from another angle.
FIG. 18 is a cross-sectional view of a control device according to an embodiment of the present invention.
FIG. 19 is a diagram for explaining the connection structure of electronic components in a control device according to an embodiment of the present invention.
FIG. 20 is a diagram for explaining a heat dissipation structure inside a control device according to an embodiment of the present invention.

### [BEST MODE]

Hereinafter, preferred embodiments of the present invention will be described in detail with reference to the accompanying drawings.

However, the technical idea of the present invention is not limited to some embodiments to be described, but may be implemented in various forms, and inside the scope of the technical idea of the present invention, one or more of the constituent elements may be selectively combined or substituted between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention.

In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used. These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or disposed in "on (above)" or "below (under)" of each component, "on (above)" or "below (under)" means that it includes not only the case where the two components are directly in contact with, but also the case where one or more other components are formed or disposed between the two components. In addition, when expressed as "on (above)" or "below (under)", the meaning of not only an upward direction but also a downward direction With respect to one component may be included.

Hereinafter, the present invention will be described in more detail with reference to the attached drawings.

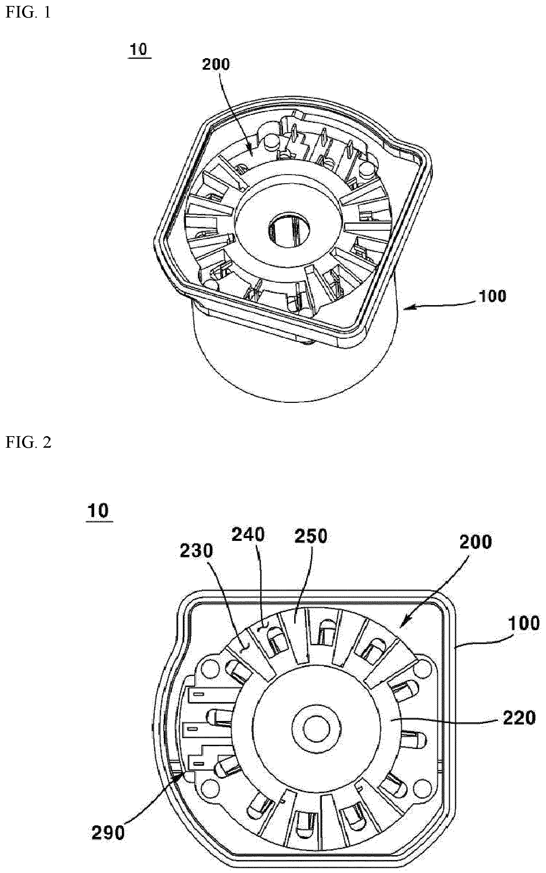

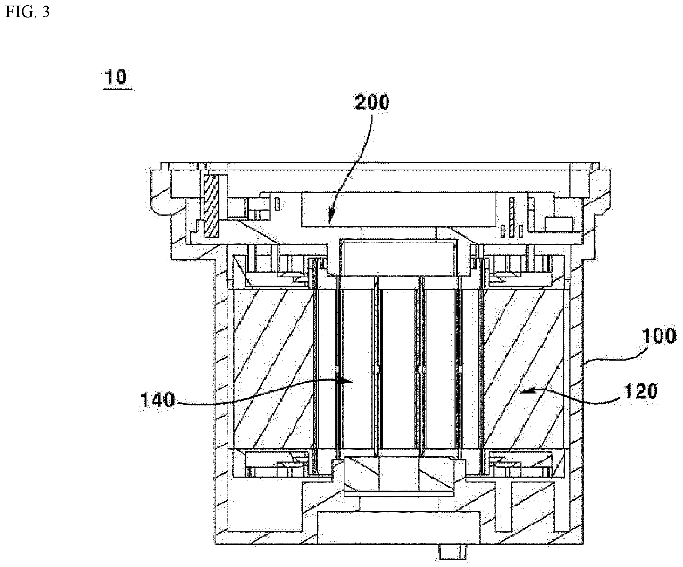

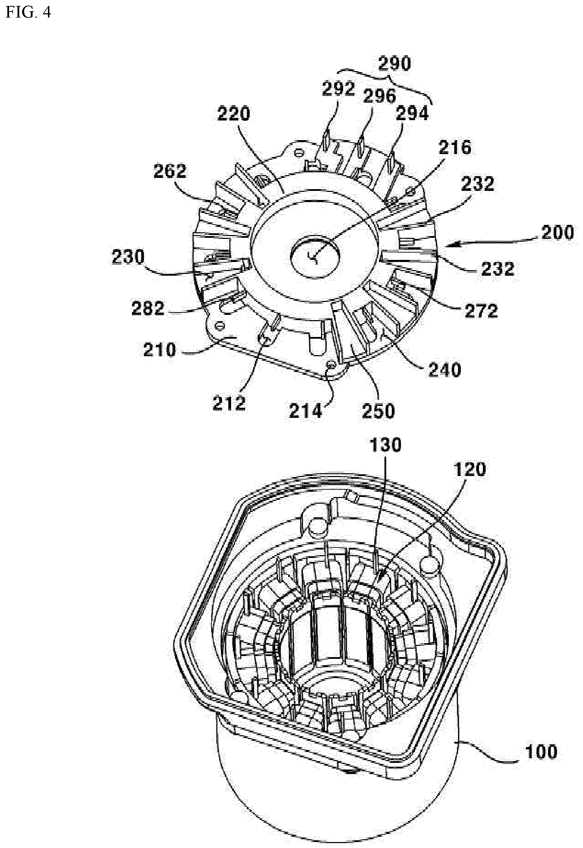

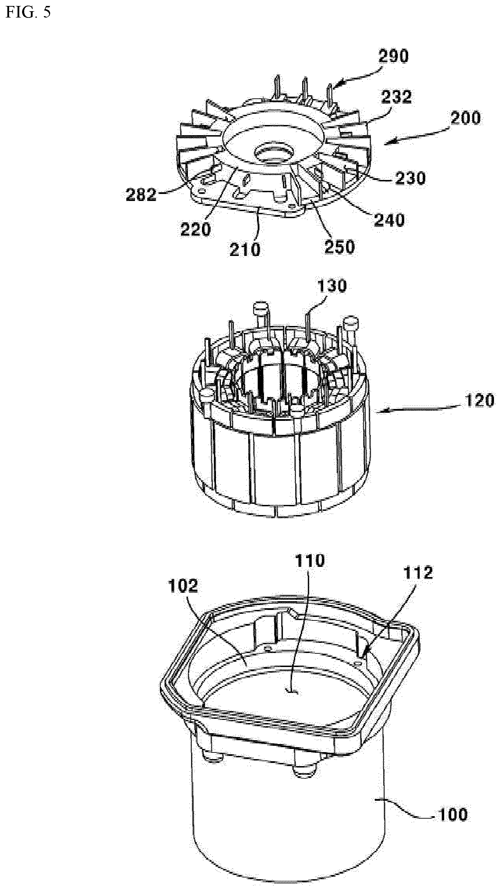

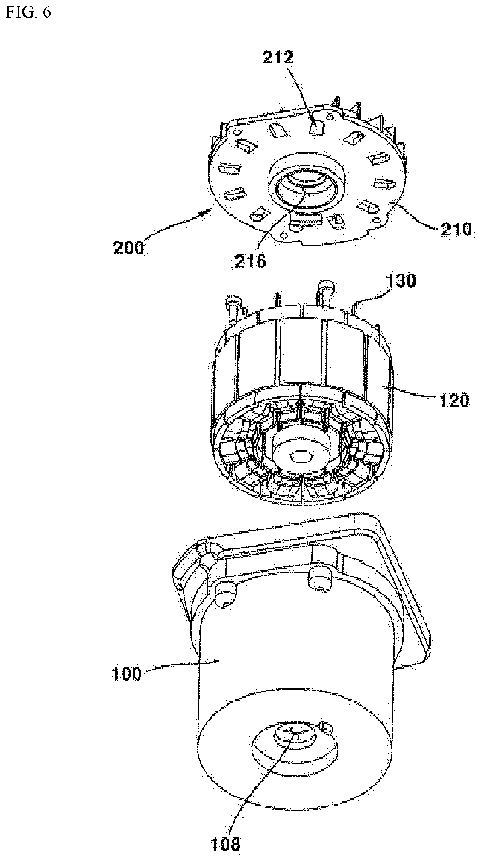

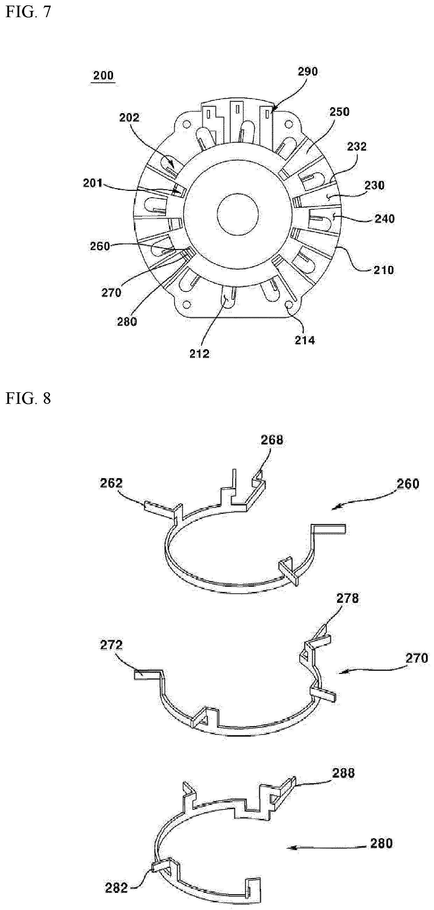

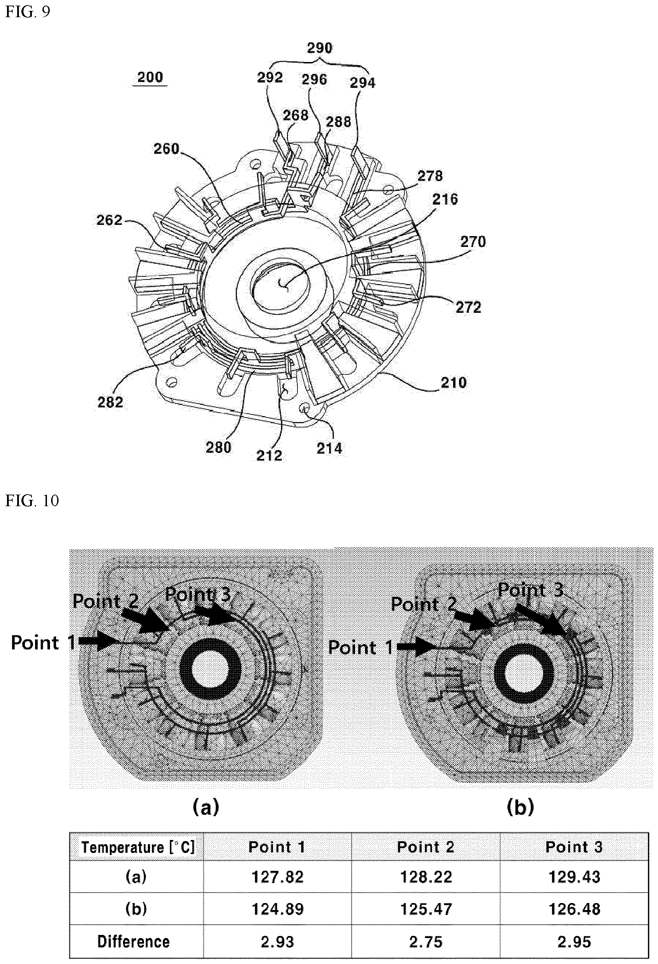

FIG. 1 is a perspective view illustrating the outer appearance of a motor according to an embodiment of the present invention; FIG. 2 is a plan view illustrating an upper surface of a motor according to an embodiment of the present invention; FIG. 3 is a cross-sectional view illustrating the configuration inside a motor according to an embodiment of the present invention; FIG. 4 is an exploded perspective view of the housing and a busbar module according to an embodiment of the present invention; FIG. 5 is an exploded perspective view of a housing, a stator, and a busbar module according to an embodiment of the present invention; FIG. 6 is a view illustrating FIG. 5 from another angle; FIG. 7 is a plan view illustrating an upper surface of a busbar module according to an embodiment of the present invention; FIG. 8 is an exploded perspective view of a plurality of busbars according to an embodiment of the present invention; and FIG. 9 is a diagram for explaining the arrangement structure of a busbar in a busbar module according to an embodiment of the present invention.

Referring to FIGS. 1 to 9, the motor **10** according to an embodiment of the present invention may comprise a housing **100**, a stator **120**, a rotor **140**, and a busbar module **200.**

The housing **100** forms the outer appearance of the motor **10** and may include a space **102** inside which the stator **120**, the rotor 14**0**, and the busbar module **200** are disposed.

The space **102** may be partitioned into a first area where the stator **120** and the rotor **140** are disposed and a second area where the busbar module **200** is disposed. The first area and the second area may be partitioned by the step **110** as a boundary. The step **110** has a shape being protruded more inward than other areas from the inner surface of the housing **100**, wherein the first area is disposed at a lower portion of the step **110**, and the second area may be disposed at an upper portion of the step **110.** The cross-sectional area of the first area may be formed to be smaller than the cross-sectional area of the second area.

A screw hole **112** may be formed on the upper surface of the step **110** so that the busbar module **200** can be screw-coupled thereto.

The stator **120** may be disposed inside the housing **100.** The stator **120** may include a stator core, an insulator surrounding an outer surface of the stator core, and a coil **130** wound around the insulator. Both ends of the coil **130** may be extended upward from the stator core and coupled to the busbar module **200.**

The coil **130** may comprise a first coil having a first polarity, a second coil having a second polarity different from the first polarity, and a third coil having a third polarity different from the first polarity and the second polarity.

The rotor **140** may be disposed inside the stator **120.** The rotor **140** may include a rotor core and a magnet being disposed on the outer surface of the rotor core. The magnet may be disposed to face the coil **130.** Therefore, the rotor **140** can rotate due to electromagnetic interaction between the magnet and the coil **130.**

The shaft is coupled to the center of the rotor **140** and can rotate together with the rotor **140.** Both ends of the shaft may be extended upward and downward, respectively, of the housing **100**; one end of the shaft protrudes downward through an opening **108** (refer to FIG. 6) formed on the lower surface of the housing **100**; and the upper end of the shaft may be protruded upward through the opening **216** (refer to FIG. 4) formed in the center of the bus module **200.**

At least one bearing may be disposed inside the housing **100** to support rotation of the shaft.

The busbar module **200** may be disposed at an upper portion of the stator **120.** The busbar module **200** may be disposed in the second area. The busbar module **200** may be coupled to the upper surface of the step **110.**

The busbar module **200** electrically connects the coil **130** and a controller (not shown), and thus the output of the motor **10** can be controlled through the controller. The controller may be disposed at an upper portion of the busbar module **200.**

The busbar module **200** may include a body, a busbar, a terminal **290**, and a heat transfer member **250.**

The body may form the outer appearance of the busbar module **200.** The body may form the body part of the busbar module **200.** The body may have a circular cross-sectional shape. The body may include two or more step areas having different heights.

In detail, the body may include a plate-shaped first body **210** and a second body **220** being protruded upward from the upper surface of the first body **210** and has a ring-shaped cross section. An opening **216** penetrating from the upper surface to the lower surface may be formed in the center of the body, and the shaft may be protruded upward through the opening **216.**

The first body **210** may include a hole **212** penetrating from the upper surface to the lower surface. The hole **212** may be formed to correspond to the arrangement area of the protrusions **262**, **272**, and **282** of the busbar, which will be described later. The hole **212** may be disposed in an area being overlapped with the protrusions **262**, **272**, and **282** of the busbar in an up and down direction. The end portion of the coil **130** penetrates through the hole **212** and is disposed at an upper portion of the first body **210** to be electrically connected to the busbar. The end of the coil **130** may be coupled to the protrusions **262**, **272**, and **282** of the busbar by fusing.

The first body **210** may include a coupling hole **214** penetrating from the upper surface to the lower surface, and a screw penetrates the coupling hole **214** and can be screw-coupled to the upper surface of the step **110** of the housing **100.**

The second body **220** is disposed on the first body **210**, and the cross-sectional area of the second body **220** may be smaller than the cross-sectional area of the first body **210.** With respect to the second body **220**, the first body **210** may be partitioned into a plurality of areas being spaced apart in the radial direction. For example, the central area of the first body **210** is disposed inside the second body **220**, and an edge area of the first body **210** may be disposed outside the second body **220.** At least a portion of the busbar may be disposed inside the second body **220.** A hole through which the busbar passes may be formed on the outer surface of the second body **220.**

At least a portion of the busbar may be disposed inside the second body **220**, and another portion may be protruded outward through a hole of the second body **220.** As illustrated in FIG. 8, the busbar may include a busbar body being extended in a circumferential direction, and protrusions **262**, **272**, and **282** being extended in a radial direction from the busbar body, and the busbar body is disposed inside the second body **220**, and at least a portion of the protrusions **262**, **272**, and **282** may be disposed outside the second body **220.**

The busbar body may have an arc shape with both ends spaced apart, as illustrated in FIG. 8. The protrusions **262**, **272**, and **282** may be provided in plural numbers and disposed to be spaced apart from each other along the circumferential direction of the busbar body.

The busbars may be provided in plural numbers. The plurality of busbars may comprise: a first busbar **260** being connected to the first coil; a second busbar **270** being connected to the second coil; and a third busbar **280** being connected to the third coil. At least a portion of the first to third busbars **260**, **270**, and **280** may be disposed to be overlapped along the radial direction. A second busbar **270** may be disposed outside the first busbar **260**, and a third busbar **280** may be disposed outside the second busbar **270.** To prevent electrical short circuits from occurring, an insulating member made of an insulating material may be disposed between the first busbar **260** and the second busbar **270**, and between the second busbar **270** and the third busbar **280.** The first to third busbars **260**, **270**, and **280** may be spaced apart in the radial direction through the insulating member.

Meanwhile, a first protrusion **262** being disposed in the first busbar **260**, a second protrusion **272** being disposed in the second busbar **270**, and a third protrusion **282** being disposed in the third busbar **270** may be disposed to form the same height, but unlike this, may be disposed to form a step in an up and down direction. As an example, the height of the first protrusion **262** being disposed in the first unit open area, which will be described later, may be disposed higher than the height of the second protrusion **272** being disposed in the second unit open area.

The busbar may include connection portions **268**, **278**, and **288.** The connection portions **268**, **278**, and **288** are for connection to the terminal **290** and may have a shape being extended outward from one end of the busbar body. An electrical connection can be made between the controller and the busbar through the terminal **290.** The terminal **290** may have a shape being protruded upward from the first body **210.** The terminal **290** may include: a first terminal **292** being electrically connected to the first busbar **260**; a second terminal **294** being electrically connected to the second busbar **270**; and a third terminal **296** being electrically connected to the third busbar **280.**

Meanwhile, the first body **210** and the second body **220** may be formed of an insulating material. For example, the first body **210** and the second body **220** may be made of plastic.

The busbar may include a first area **201** and a second area **202.** The first area **201** and the second area **202** may be exposed to the outside of the body in an axial direction. The first area **201** may be a portion of the busbar **body.** The second area **202** may be a portion of the protrusions **262**, **272**, and **282.** With respect to the circumferential direction, the first area **201** and the second area **202** may be disposed so as not to be overlapped with each other. With respect to the radial direction, the first area **201** and the second area **202** may be disposed so as not to be overlapped with each other.

The busbar module **200** may include a first open area **230** and a second open area **240.** The first open area **230** and the second open area **240** may each be provided in plural numbers and disposed alternately along the circumferential direction. When viewed from the upper portion, the first open area **230** and the second open area **240** may have a groove shape that is recessed lower than the other areas. A side wall **232** is disposed between the first open area **230** and the second open area **240**, and the first open area **230** and the second open area **240** may be partitioned from each other through the side wall **232.**

Since the first open area **230** and the second open area **240** are disposed alternately along the circumferential direction, when the second open area includes a first unit open area and a second unit open area being spaced apart in the circumferential direction, the first open area **230** may be disposed between the first unit open area and the second unit open area.

The hole **212** and the protrusions **262**, **272**, and **282** may be disposed in the second open area **240.** Accordingly, the protrusions **262**, **272**, and **282** may be exposed upward through the second open area **240.**

The first area of the busbar may be disposed in the first open area **230.** To this end, the radial length of the first open area **230** may be formed to be longer than the radial length of the second open area **240.** At least a portion of the first open area **230** may be disposed to be overlapped with the second body **220** in the circumferential direction. In this case, the second body **220** may include a groove area that opens the busbar body upward. The second open area **240** may be disposed outside the second body **220** in the radial direction. The radial length of the side wall forming the inner circumferential surface of the first open area **230** may be formed to be longer than the radial length of the side wall forming the inner circumferential surface of the second open area **240.** The circumferential length of the first open area **230** may be smaller than the circumferential length of the second open area **240.**

The heat transfer member **250** may be disposed in the first open area **230.** The heat transfer member **250** may be disposed on the bottom surface of the first open area **230.** The cross-sectional shape of the heat transfer member **250** may be formed to correspond to the cross-sectional shape of the first open area **230.** The heat transfer member **250** may have a predetermined thickness. The heat transfer member **250** is made of a material with excellent thermal conductivity that is different from the material of the body, and may be in contact with the busbar. The heat transfer member **250** may be in contact with the first area of the busbar. The heat transfer member **250** may be in contact with the lower surface of the first area. Accordingly, the heat of the busbar is transmitted outward in the radial direction through the heat transfer member **250**, and heat dissipation can be accomplished through the remaining area of the heat transfer member **250** being exposed upward.

Meanwhile, in the present embodiment, the heat transfer member **250** is disposed only in the first open area **230** as an example, but this is not limited to this, and the heat transfer member **250** may also be disposed in the second open area **240.** In addition, the heat transfer member **250** may be provided in the first open area **230** by applying and curing a liquid heat dissipation material to the first open area **230**, but unlike this, the solid heat transfer member **250** may be directly coupled to the first open area **230**, and in this case, the side wall **232** may be omitted from the body.

According to the above structure, since the busbar is exposed above the body through a plurality of open areas, there is an advantage in that heat dissipation efficiency is enhanced due to an increase in heat dissipation area.

In addition, since the busbar has a structure in which heat is directly dissipated through the heat transfer member, there is an advantage that heat can be easily discharged to the outside along the predetermined path.

FIG. 10 is a diagram for explaining heat dissipation efficiency between a busbar module according to the prior art and a busbar module according to an embodiment of the present invention.

Referring to FIG. 10, as a result of measuring the temperature of a busbar module according to the prior art (refer to FIG. 10(a)) and three arbitrarily designated areas within the busbar module (FIG. 10(b)) according to an embodiment of the present invention, it can be seen that the busbar module **200** according to an embodiment of the present invention has a temperature reduction effect of about 30 °C compared to the busbar module according to the prior art.

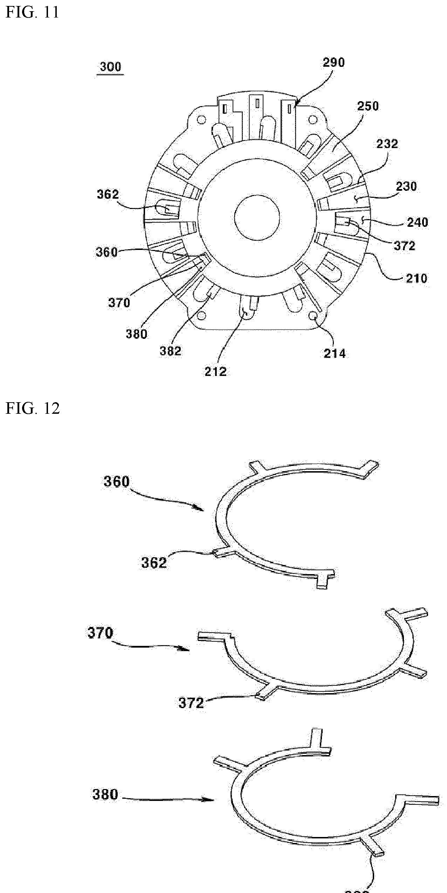

FIGS. 11 and 12 are diagrams illustrating a modified embodiment of a busbar module according to an embodiment of the present invention.

In the present modified embodiment, other parts are the same as the busbar module described above, but there are differences depending on the shape of the busbar.

Referring to FIGS. 11 and 12, in the present modified embodiment, the busbar may include first to third busbars **360**, **370**, and **380.** The first to third busbars **360**, **370**, and **380** may each include a busbar body and protrusions **362**, **372**, and **382** being protruded radially outward from the busbar body, but the shape of the busbar body may have a plate shape.

More specifically, in an embodiment previously described, the area of the upper and lower surfaces of the busbar body and protrusion **262**, **272**, and **282** has a shape that is smaller than the area of the side surface, but in the present modified embodiment, the area of the upper and lower surfaces of the busbar body and the protrusions **362**, **372**, and **382** may have a plate shape larger than the area of the side surface. In this case, the busbar bodies of each of the first to third busbars **360**, **370**, and **380** may be disposed to form the same height and disposed along the radial direction, or may be disposed to have a step to form different heights.

Hereinafter, a control device according to an embodiment of the present invention will be described.

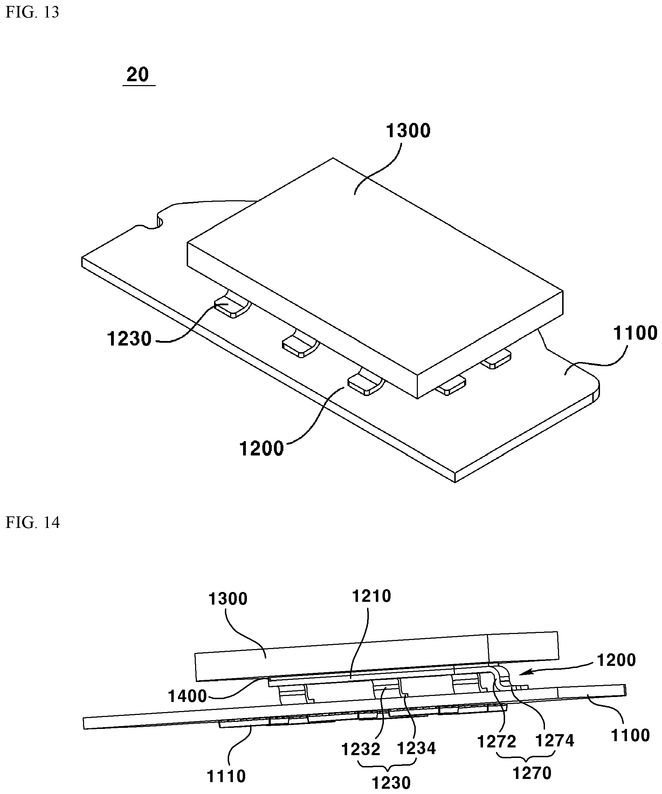

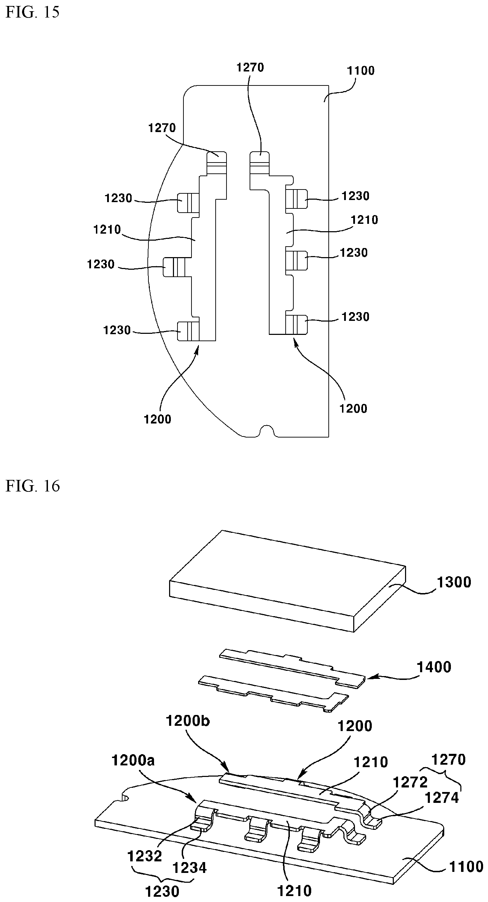

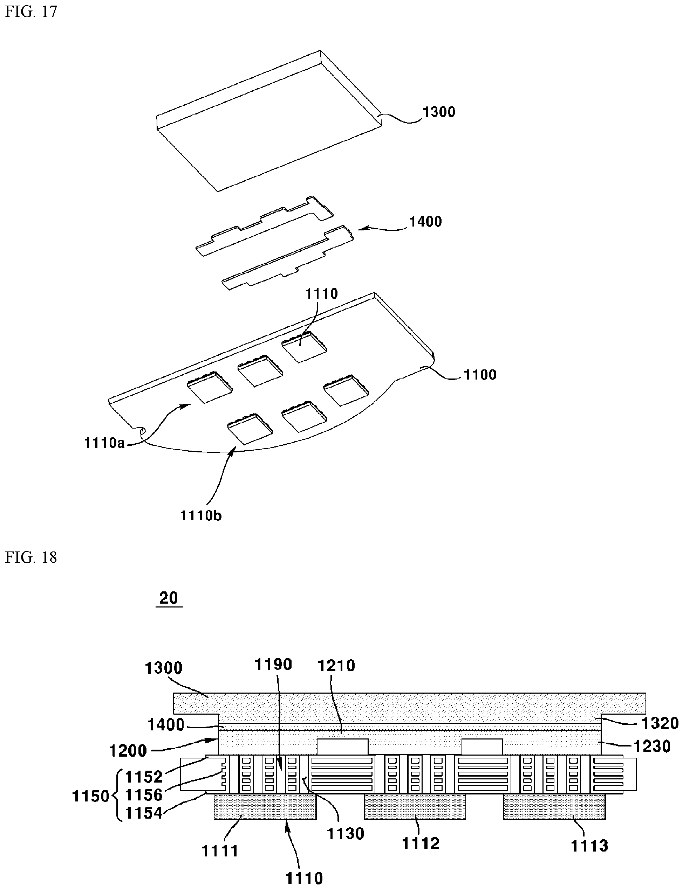

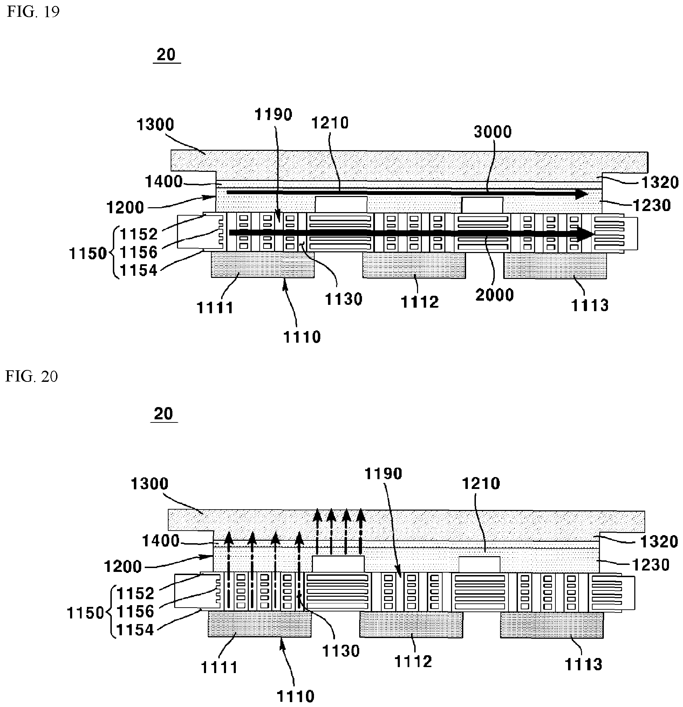

FIG. 13 is a perspective view of a control device according to an embodiment of the present invention; FIG. 14 is a perspective view illustrating a side surface of a heat dissipation structure in a control device according to an embodiment of the present invention; FIG. 15 is a plan view illustrating a terminal coupled to a printed circuit board according to an embodiment of the present invention; FIG. 16 is an exploded perspective view of a heat dissipation structure in a control device according to an embodiment of the present invention; FIG. 17 is a view illustrating FIG. 16 from another angle; FIG. 18 is a cross-sectional view of a control device according to an embodiment of the present invention; FIG. 19 is a diagram for explaining the connection structure of electronic components in a control device according to an embodiment of the present invention; and FIG. 20 is a diagram for explaining a heat dissipation structure inside a control device according to an embodiment of the present invention.

Referring to FIGS. 13 to 20, the control device **20** according to an embodiment of the present invention may comprise a printed circuit board **1100,** an electronic component **1110,** a terminal **1200**, a cover **1300**, and a filler **1400.**

The printed circuit board **1100** may be formed in a plate shape. The printed circuit board **1100** may include one surface being coupled with the electronic component **1110,** and another surface opposing the one surface being coupled with the terminal **1200.** One or more elements for driving the control device **20** may be disposed on one surface or the other surface of the printed circuit board **1100.** The printed circuit board **1100** may be disposed in a housing (not shown) that forms the outer shape of the control device **20.**

The printed circuit board **1100** may include a plurality of holes **1130.** The plurality of holes **1130** may be disposed to correspond to the arrangement area of the electronic component **1110.** The plurality of holes **1130** may each be formed to penetrate from one surface of the printed circuit board **1100** to the other surface. The plurality of holes **1130** may be provided in plural numbers and disposed to be spaced apart from one another. Based on a single electronic component **1110**, a plurality of holes **1130** may be formed in an area of the printed circuit board **1100** being coupled with the electronic component **1110.** For example, as illustrated in FIG. 18, four holes **1130** may be disposed in the printed circuit board **1100** being coupled with a single electronic component **1110.** The hole **1130** may also be referred to as a via hole.

The printed circuit board **1100** may include a metal layer **1150.** The metal layer **1150** is connected to the electronic component **1110** or the terminal **1200**, and may be a circuit pattern that electrically connects the printed circuit board **1100,** the electronic component **1110,** and the terminal **1200** to one another.

The metal layer **1150** may comprise: a first metal layer **1154** disposed on one side of the printed circuit board **1100**; a second metal layer **1152** disposed on the other side of the printed circuit board **1100**; a third metal layer **1156** connecting the first metal layer **1154** and the second metal layer **1152** and being disposed on the inner surface of the hole **1130.** The metal layer **1150** may have a cross-sectional shape approximately in the shape of a letter " 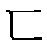 " due to the first metal layer **1154**, the second metal layer **1152**, and the third metal layer **1156.**

The first metal layer **1154** may be in contact with the electronic component **1110.** The first metal layer **1154** may be electrically connected to the electronic component **1110.**

The second metal layer **1152** may be in contact with the terminal **1200.** The second metal layer **1152** may be electrically connected to the terminal **1200.**

The third metal layer **1156** connects the first metal layer **1154** and the second metal layer **1152**, and thus, the terminal **1200** and the electronic component **1110** can be electrically connected. The first metal layer **1154**, the second metal layer **1152**, and the third metal layer **1156** may be formed as one body.

The hole **1130** may be filled with a metal material **1190.** The metal material **1190** may fill at least some among the plurality of holes **1130.** The metal material **1190** may be a solder solution for soldering the electronic component **1110** or the terminal **1200** to the surface of the printed circuit board **1100.** The metal material **1190** may be filled in the hole **1130** and connected to the metal layer **1150.**

The electronic component **1110** may be disposed on one surface of the printed circuit board **1100.** The electronic component **1110** may be coupled to the lower surface of the printed circuit board **1100.** The electronic component **1110** may be soldered to the lower surface of the printed circuit board **1100.** The electronic component **1110** may be coupled to the printed circuit board 1100 to face the hole **1130.** The electronic component **1110** is connected to the metal layer **1150**,
so that the electronic components **1110** may be provided in plural numbers and disposed to be spaced apart from one another.

The electronic components **1110** may be provided in plural numbers and disposed to be spaced apart from one another. The electronic component **1110** may include an FET device. The electronic component **1110** may be referred to as a switching element. The electronic component **1110** may include a first switching element **1111**, a second switching element **1112**, and a third switching element **1113.** The first to third switching elements **1111**, **1112**, and **1113** may be disposed to be spaced apart from one another. The first switching element **1111**, the second switching element **1112**, and the third switching element **1113** may each include a terminal being connected to the metal material **1190.** For example, a first terminal is disposed on one surface of the first switching element **1111** facing the printed circuit board **1100,** a second terminal is disposed on one surface of the second switching element **1112** facing the printed circuit board **1100,** and a third terminal may be disposed on one surface of the third switching element **1113** facing the printed circuit board **1100.** Each of the first to third terminals is in contact with the metal material **1190**, so that the first to third switching elements **1111**, **1112**, and **1113** can be electrically connected to one another.

The printed circuit board **1100** may include a first path **2000** (refer to FIG. 19). The first path **2000** may electrically connect at least some of the plurality of electronic components **1110** to one another. The first path **2000** may be formed inside the printed circuit board **1100** to electrically connect the metal material **1190** or the metal layer **1150** filled in each of the plurality of holes **1130** to one another. Through the first path **2000**, the first switching element **1111** and the second switching element **1112**, the second switching element **1112** and the third switching element **1113**, and the first switching element **1111** and the third switching element **1113** may be electrically connected to one another.

The control device **20** may include the terminal **1200.** The terminal **1200** may be disposed on the other surface of the printed circuit board **1100.** With respect to the printed circuit board **1100,** the terminal **1200** may be disposed to face the electronic component **1110.** With respect to the hole **1130**, the electronic component **1110** may be disposed at one end of the hole **1130**, and the terminal **1200** may be disposed at the other end of the hole **1130.**

The terminal **1200** may electrically connect the plurality of electronic components **1110** to one another. The terminal **1200** may be made of a metal material.

The terminals 1200 may be provided in plural and disposed to be spaced apart from one another. Each of the plurality of terminals **1200** may be disposed to electrically connect the plurality of electronic components **110** to one another. For example, two terminals **1200** are provided and six electronic components **1110** are provided so that any one terminal electrically connects three electronic components **1110** to one another and the other terminal can electrically connect the remaining three electronic components **1110** to one another. In this case, the intensity of voltage or current flowing through each of the plurality of terminals **1200** may be different.

The terminal **1200** may include a body portion **1210** and a terminal portion **1230.**

The body portion **1210** may be disposed to be spaced a predetermined distance from the other surface of the printed circuit board **1100.** For example, as illustrated in FIG. 14, the lower surface of the body portion **1210** may be spaced apart from the upper surface of the printed circuit board **1100** by a predetermined distance. The body portion **1210** may be disposed in an area not being overlapped with the plurality of holes **1130.**

The terminal portion **1230** is extended outward from the body portion **1210** and may be coupled to the other surface of the printed circuit board **1100.** The terminal portion **1230** may have an area being bent at least once. The terminal portion **1230** may include: a first area **1232** being protruded downward from the side surface of the body portion **1210**; and a second area **1234** being bent from an end of the first area **1232** being coupled to the other surface of the printed circuit board **100.** The second area **1234** may be parallel to the body **1210**, and the first area **1232** may be disposed perpendicular to the first area **1234** or the body **1210.**

The terminal portion **1230** may be coupled to cover the plurality of holes **1130.** The lower surface of the second area **1234** may be coupled to the upper portion of the plurality of holes **1130.** One end of the plurality of holes **1130** may be covered through the second area **1234.** The terminal portion **1230** may be in contact with the metal layer **1150** and the metal material **1190.** The terminal portion **1230** may be soldered to the surface of the printed circuit board **1100.** The lower surface of the second area **1234** may be soldered to the upper surface of the printed circuit board **1100.**

With respect to the single body portion **1210**, a plurality of terminal portions **1230** may be provided and disposed to be spaced apart from one another.

The terminal **1200** may include a second path **3000** electrically connecting at least some among the plurality of electronic components **1110.** As previously described, the terminal **1200** may be connected to the plurality of holes **1130** through the terminal portion **1230.** In this case, the terminal portion **1230** may be connected to the metal layer **1150** or the metal material **1190.** Accordingly, the plurality of electronic components **1110** can be electrically connected to each other through the metal material **1190**, one terminal portion of the plurality of terminal portions **1230**, a second path **3000** being connected to the body portion **1210** and another terminal portion among the plurality of terminal portions **1230.** Through the second pass **3000**, the first switching element **1111** and the second switching element **1112**, the second switching element **1112** and the third switching element **1113**, and the first switching element **1111** and the third switching element **1113** can be electrically connected to one another.

Meanwhile, each of the plurality of terminals **1200** may additionally include a connection portion **1270** in addition to the terminal portion **1230.** The connection portion **1270** is extended from the outside of the body portion **1210** to electrically connect the terminal **1200** and other components inside the printed circuit board **1100.** For example, the connection portion **1270** may be electrically connected to another component in the printed circuit board **1100** or a power supply unit that provides power to the electronic component **1110.** The connection portion **1270** also has an area being bent more than once, and may include a third area **1272** being extended from the body portion **1210** and a fourth area **1274** being bent from the third area **1272** and coupled to the other surface of the printed circuit board **1100.**

The control device **20** may include the cover **1300.** The cover **1300** may be disposed to cover the other surface of the printed circuit board **1100.** The cover **1300** may be disposed outside the terminal **1200** with respect to the printed circuit board **1100.** The cover 1300 may form the outer shape of the control device **20.** In this case, the cover **1300** may also be referred to as a housing. The cover **1300** may be made of a metal material.

The cover **1300** may include a protrusion **320** being protruded inward. The protrusion **1320** may pressurize the upper surface of the body **1210.** The protrusion **1320** may be in contact with the upper surface of the body portion **1210.** The cross-sectional shape of the protrusion **1320** may be formed to correspond to the cross-sectional shape of the body portion **1210.**

The control device **20** may include a filler **1400.** The filler **1400** may be disposed between the cover **1300** and the terminal **1200.** The filler **1400** may have one surface facing the upper surface of the body **1210** and the other surface facing the lower surface of the protrusion **1320.** Both surfaces of the filler **1400** may be in contact with the cover **1300** and the terminal **1200**, respectively. The filler **1400** may be a thermal filler made of a thermally conductive material. The filler **1400** may be formed of a plate material. The filler **1400** may be formed to correspond to the cross-sectional shape of the body portion **1210.** An adhesive is disposed on the surface of the filler **1400** being in contact with the cover **1300** or the terminal **1200**, so that it can be coupled to the cover **1300** or the terminal **1200**, respectively.

According to the above structure, as illustrated in FIG. 20, heat generated from the electronic component **1110** may be sequentially conducted through the metal material **1190**, the terminal **1200**, the filler **1400**, and the cover **1300** and be discharged to the outside. In this case, the heat dissipation path of the electronic component **1110** defined by the metal material **1190**, the terminal **1200**, the filler **1400**, and the cover **1300** may be referred to as a first path.

Meanwhile, heat generated from the electronic component **1110** may be discharged to the outside at the highest rate through the first path. For example, more than 80% of the heat generated by the electronic component **1110** may be discharged to the outside through the first path.

According to the control device according to the present embodiment, by forming an additional connection path between the pluralities of electronic components **1110** through the terminal **1200**, there is an advantage in that the amount of heat generated by the printed circuit board **1100** can be reduced due to a reduction in the resistance component of the electrical connection section.

In addition, since the heat of the electronic component **1110** is directly transferred to the terminal **1200**, the filler **1400**, and the cover **1300** through the metal material **1190** filled inside the hole **1130**, there is an advantage that the heat dissipation area can be increased and heat dissipation efficiency can be enhanced.

Although the embodiment of the present invention has been described above with reference to the accompanying drawings, those of ordinary skill in the art to which the present invention belongs will understand that the present invention may be embodied in other specific forms without changing the technical spirit or essential features thereof. Therefore, it should be understood that the embodiments described above are illustrative in all respects and not restrictive.

## Claims

1. A motor comprising:
a body;
a busbar coupled to the body; and
a heat transfer member disposed on the body,
wherein the body includes a first open area for exposing the busbar in an axial direction, and a second open area,
wherein the second open area includes a first unit open area and a second unit open area, and
wherein the heat transfer member is in contact with the busbar in the first open area and is disposed between the first unit open area and the second unit open area.

2. The motor according to claim 1,
wherein the heat transfer member is formed of a material different from the body.

3. The motor according to claim 1,
wherein a side wall is disposed between the first open area and the second open area.

4. The motor according to claim 3,
wherein a length of the side wall forming an inner surface of the first open area in a radial direction is greater than the length of the side wall in a radial direction forming an inner surface of the second open area.

5. The motor according to claim 1,
wherein a length of the first open area in a circumferential direction is smaller than a length of the second open area in a circumferential direction.

6. The motor according to claim 1,
wherein the busbar includes a busbar body extended in a circumferential direction and a protrusion extended in a radial direction from the busbar body,
wherein at least a portion of the busbar body is disposed in the first open area, and
wherein at least a portion of the protrusion is disposed in the second open area.

7. The motor according to claim 1,
wherein a cross-sectional shape of the heat transfer member corresponds to a cross-sectional shape of the first open area.

8. The motor according to claim 7,
wherein the second body includes a groove that opens the busbar upward.

9. The motor according to claim 1,
wherein the busbar includes a first busbar of a first polarity, a second busbar of a second polarity different from the first polarity, and a third busbar of a third polarity different from the first polarity and the second polarity, and
wherein the first to third busbars are disposed to be spaced apart from each other along a radial direction.

10. A control device comprising:
a printed circuit board including a plurality of holes;
a plurality of electronic components disposed on the plurality of holes on one surface of the printed circuit board; and a terminal disposed on the other surface of the printed circuit board,
wherein the printed circuit board includes a first path electrically connecting at least a apart among the plurality of electronic components, and
wherein the terminal includes a second path connected to the plurality of holes and electrically connecting at least a part among the plurality of electronic components.
